# EUROPEAN PATENT APPLICATION

(11) **EP 4 312 250 A1**
(43) Date of publication of application: **31.01.2024**
(21) Application number: 23186667.4
(22) Date of filing: 20.07.2023
(51) Int. Cl.: H01L 21/48, H01L 21/56, H01L 23/495

(54) **METHOD OF MANUFACTURING SEMICONDUCTOR DEVICES, CORRESPONDING SUBSTRATE AND SEMICONDUCTOR DEVICE**

(30) Priority: 28.07.2022 IT 202200016008
(71) Applicant: STMicroelectronics S.r.l., 20864 Agrate Brianza (MB) (IT)
(72) Inventor: VITELLO, Dario, I-23807 Merate (Lecco) (IT)
(74) Representative: Bosotti, Luciano

(57) **Abstract**

A method of manufacturing semiconductor devices comprises:
providing a semiconductor die mounting substrate such as a pre-molded leadframe (12) comprising a plurality of die pads (12A) having opposed first and second surfaces as well as tie bars (20) projecting therefrom,
mounting semiconductor dice (14) at the first surface of die pads in the plurality of die pads (12A), and
molding encapsulation material onto the semiconductor dice (14) mounted at the first surface of the die pads (12A).

A plurality of semiconductor devices is thus produced, with the semiconductor devices (10) in the plurality mutually coupled via the tie bars (20). The tie bars (20) are cut transverse to their longitudinal direction (X20) at an intermediate singulation location to singulate the semiconductor devices into individual semiconductor devices. The tie bars (20) have a hollowed-out portion (20A) with a channel-shaped cross-sectional profile at the intermediate singulation location. Easier-to-cut tie bars (20) can be provided without impairing their stiffness in comparison with tie bars having full rectangular/square cross-sectional shapes.

## Description

### Technical field

The description relates to manufacturing semiconductor devices.

Solutions as described herein can be applied to packaging integrated circuits (ICs), for instance in packages including a leadframe with an exposed pad.

### Background

In current manufacturing processes of semiconductor devices, plural devices manufactured concurrently in a chain or strip are then separated into single individual devices in a final "singulation" step.

Package singulation is the last step of the assembly process: once a protective encapsulation is molded to complete the package, each individual package is separated from the rest of chain or strip.

This involves mechanically cutting (e.g., via a blade) tie bars included in a leadframe ribbon common to the devices in the chain or strip. Mechanical cutting induces stresses that may lie at the basis of leadframe/mold (encapsulation) detachment. This is an undesired effect that may in turn cause premature failure during reliability tests or during the operating life of the device.

Conventional leadframes comprise uniform, e.g., rectangular tie bars with constant thickness. This is the thickness (e.g., 0.2 mm) of the copper ribbon from which the leadframe is manufactured.

Using thinner tie bars may facilitate cutting during singulation, reducing stresses that may lie at the basis of leadframe/mold (encapsulation) detachment. Using thinner tie bars however increases the risk of die pad tilt during the assembly process.

### Object and summary

Solutions as described herein aim at addressing the issues discussed in the foregoing.

Such an object can be achieved via a method having the features set forth in the claims that follow.

One or more embodiments also relate to a corresponding substrate (e.g., a leadframe strip or ribbon for use in manufacturing semiconductor devices).

One or more embodiments also relate to a corresponding semiconductor device.

The claims are an integral part of the technical teaching provided herein in respect of the embodiments.

The solutions presented herein comprise a substrate such as a leadframe in which tie bars have a channel-shaped (U-shaped) cross-section at least at their median part that is cut during singulation after molding.

Such a channel or (inverted) U shape can be bestowed on the tie bars done during leadframe manufacturing using a coining or etching process, for instance.

A higher stiffness (a higher moment of inertia) of the tie bars can thus be achieved in comparison with tie bars of constant cross section. This provides improved support of the die pads avoiding tilt/bending. At the same time, channel- or U-shaped tie bars will be easier to be cut during singulation.

In solutions presented herein, coining or etching a recess in leadframe tie bars facilitates providing a channel- or U-shape section in the median portion of these tie bars. After mounting semiconductor chips or dice on the die pads in the leadframe and molding an encapsulation thereon, singulation of the individual package units from the leadframe may take place cutting through the channel-shaped (U-shaped) median portion of the tie bars.

Visual inspection of resulting package flanks will reveal the presence of such a channel shape or U-shape in the remainder of the tie bars remaining exposed at the package flanks.

### Brief description of the several views of the drawings

One or more embodiments will now be described, by way of example only, with reference to the annexed figures, wherein:
Figure 1 is a plan view from the front or top side of a semiconductor device in the process of being manufactured,
Figure 2 is a plan view from the back or bottom side of the semiconductor device of Figure 1,
Figure 3 is a plan view from the back or bottom side of the semiconductor device of Figure 1 and Figure 2 illustrated in a later stage of the assembly process,
Figure 4 is a view of the portion of Figure 1 indicated by the arrow IV reproduced on an enlarged scale and with various elements removed for clarity,
Figure 5 is a comparative diagram of characteristics of conventional tie bars and tie bars as described herein, and
Figure 6 is a side view of a semiconductor device as described herein.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description like parts or elements are indicated in the various figures with like reference signs, and a corresponding description will not be repeated for each and every figure.

Semiconductor devices as considered herein comprise a substrate (leadframe) 12 comprising one or more die pads 12A having one or more semiconductor chips or dice 14 arranged thereon plus an array of electrically conductive leads 12B.

As used herein, "chip/s" and "die/dice" will be regarded as synonyms. For simplicity, a single die pad 12A is illustrated having a single semiconductor chip or dice 14 mounted thereon.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

Essentially, a leadframe comprises an array of electrically-conductive formations (or leads, e.g., 12B) that from an outline location extend inwardly in the direction of a semiconductor chip or die (e.g., 14) thus forming an array of electrically-conductive formations from a die pad (e.g., 12A) configured to have at least one semiconductor chip or die 14 attached thereon. This may be via conventional means such as a die attach adhesive (a die attach film or DAF, for instance).

A leadframe 12 as illustrated herein can be of the pre-molded type, that is a type of leadframe comprising a sculptured metal (e.g., copper) structure comprising die pads 12A and leads 12B formed by etching a metal sheet and including empty spaces that are filled by a resin 12C "pre-molded" on the sculptured metal structure.

Semiconductor devices as considered herein comprise electrically conductive formations (e.g., wires in a wire bonding pattern) coupling the semiconductor chip(s) 14 to leads 12B (outer pads) in the substrate 12 as well.

Such a wire bonding pattern is not visible in the figures for simplicity.

An insulating encapsulation (e.g., a resin) 16 is molded on the assembly thus formed to complete the plastic body of the device.

As an (at least partial) alternative to a wire bonding pattern as discussed previously, solutions as described herein may include electrically conductive formations provided via laser direct structuring (LDS) of an encapsulation of LDS material. Documents such as US 2018/342453 A1, US2019/115287 A1, US 2020/203264 A1, US 2020/321274 A1, US 2021/050226 A1, US 2021/050299 A1, US 2021/183748 A1, or US 2021/305203 A1 (all assigned to the same assignee of the present application) are exemplary of the use of LDS technology.

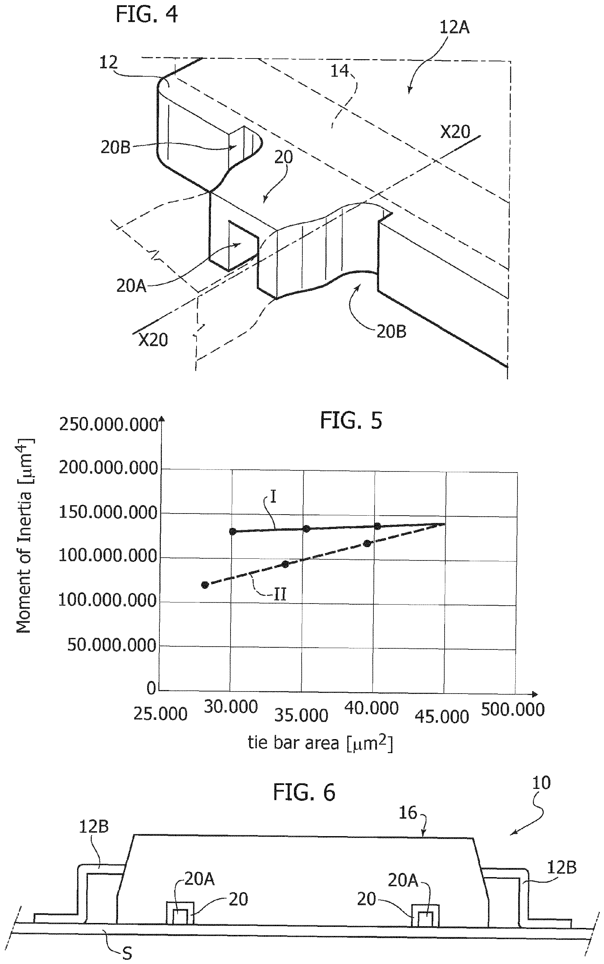

As illustrated in the side view of Figure 6, devices 10 as considered herein are intended to be mounted on a substrate S such as a printed circuit board (PCB) using solder material for instance (not visible in the figures),

A device structure as discussed so far is conventional in the art, which makes it unnecessary to provide a more detailed description herein.

The present description relates to a manufacturing process of semiconductor devices wherein plural devices are manufactured concurrently to be finally separated into individual devices in a singulation step.

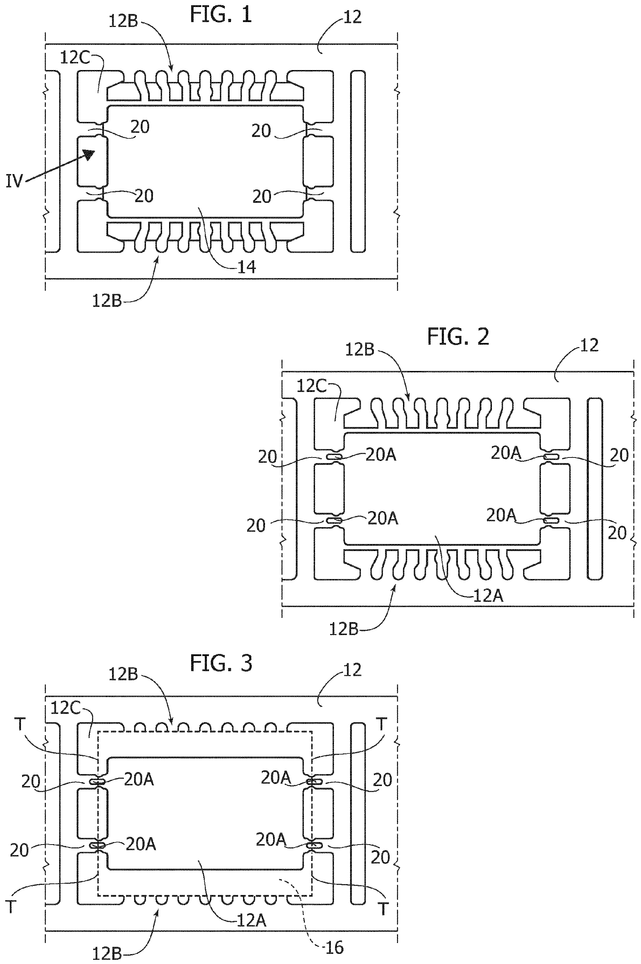

To that effect a chain or strip of devices are manufactured concurrently using, e.g., a strip-like leadframe 12 (a section of such a leadframe is visible in Figures 1 to 3) arranging the dice or chips 14 onto respective die pads 12A. These die pads are coupled to the strip structure via so-called tie bars 20.

Once the plastic body of the devices is completed by molding the insulating encapsulation 16 (see Figure 3), individual devices 10 are separated from the chain or strip in a singulation step where the tie bars 20 are severed (e.g., cut via a rotary blade) at cutting lines/planes T.

Singulation as discussed so far is likewise conventional in the art, which makes it unnecessary to provide a more detailed description herein.

To summarize, such an assembly process comprises providing a semiconductor die mounting substrate (a planar leadframe 12, for instance) comprising a plurality of die pads 12A having opposed first and second surfaces as well as tie bars 20 projecting (radially) from the die pads 12A (in the plane of the substrate 12). The tie bars have a longitudinal direction (X20).

Semiconductor dice 14 are mounted at the first surface of the die pads 12A and encapsulation material 16 is molded onto the semiconductor dice 14 mounted at the first surface of the die pads 12A, so that a plurality of semiconductor devices 10 that are mutually coupled via the tie bars 20 projecting from the die pads 12A.

As discussed, the encapsulation material 16 can be:
an insulating resin (e.g., an epoxy resin) molded onto the semiconductor dice 14 mounted at the first surface of the die pads 12A and incorporating (embedding) wire bonding patterns of wires electrically coupling each die 14 with leads in a respective array of leads 12B of the leadframe 12,
a laser-activatable material to which laser machining (e.g., laser direct structuring, LDS) and (electroless/electrolytic) metal growth can be applied to provide electrically conductive formations (vias/traces) electrically coupling each die 14 with leads in a respective array of leads 12B of the leadframe 12 (see the commonly-owned patent documents mentioned in the foregoing).

The bars 20 are finally cut transverse to their longitudinal direction X20 at an intermediate singulation location. The semiconductor devices 10 are thus singulated into individual semiconductor devices.

As illustrated, the semiconductor die mounting substrate 12 is a ribbon substrate comprising a plurality of die pads 12A distributed along the length of the ribbon substrate 12 with the tie bars 20 projecting therefrom with their longitudinal direction X20 extending lengthwise of the ribbon substrate.

As visible in Figure 4, the tie bars 20 may have an hourglass shape with a narrowed waist portion and cutting takes place along cutting lines T halfway the waist portion.

As discussed, stress induced by the mechanical cut can induce detachment of the leadframe 12 from the encapsulation 16; this may undesirably cause premature failure during reliability tests or the operating life of the device 10.

Conventional leadframes 12 comprises uniform, e.g., rectangular tie bars 20 with a constant thickness: this is the thickness (e.g., 0.2 mm) of the metal ribbon - usually a copper ribbon - from which the leadframe 12 is manufactured.

Decreasing the (uniform) thickness of rectangular tie bars facilitates cutting at lines T to the detriment of the stability of the die pads 12A.

In solutions as discussed herein these issues are addressed by bestowing on the tie bars 20 a channel-shaped (U-shaped) cross-section at least at their median part that is expected to be cut during singulation after molding.

That is, in solutions as discussed herein the tie bars 20 have a hollowed-out portion 20A at the intermediate singulation location. The tie bars 20 thus have at the intermediate singulation location a channel-shaped cross-sectional profile.

Figure 4 (this is a view of the portion of Figure 1 indicated by the arrow IV reproduced on an enlarged scale, where various elements such as the pre-mold resin 12C are removed for clarity) shows that the tie bars 20 of the examples presented herein still have an "envelope" thickness equal to the thickness (e.g., 0.2 mm) of the metal ribbon from which the leadframe 12 is manufactured.

The tie bars 20 of the examples presented herein have at their intermediate section a hollowed-out channel shape (a U-shape is exemplary of such a channel shape) due to the presence of a cavity 20A.

The cavity 20A can result from a coining or etching process, for instance, during leadframe manufacturing.

Advantageously, the cavities 20A do not extend over the whole length of the tie bars 20 (in the longitudinal direction X20), but just at the intermediate section of the tie bars 20, e.g., at the location where cutting is expected to take place during singulation (see the planes T in Figure 3).

During singulation, the tie bars 20 are cut (at the planes T of Figure 3) essentially halfway their length.

In the enlarged view of Figure 4 one half of a tie bar 20 which may result from such cutting is shown in full line, while the other half is shown in dashed lines; these two halves are separated from each other during the singulation step.

The enlarged view of Figure 4 highlights the overall (lengthwise) hourglass shape of the tie bars 20 illustrated therein, with the cavity 20A advantageously extending (only) at the intermediate narrowed waist portion of the hourglass-shaped tie bars 20.

The enlarged view of Figure 4 also illustrates a cavity 20A such that the channel shape thereof opens out at the back or bottom side of the leadframe 12 (opposite the front or top surface where the dice 14 are mounted).

That is, the tie bars 20 have a hollowed-out portion 20A at the intermediate singulation location, with the channel-shaped cross-sectional profile opening at the (second) surface of the die pads 12A opposite the (first) surface where the dice 14 are mounted.

While advantageous, this arrangement is not mandatory, insofar as the cavity 20A can be such that the channel shape opens out at the front or top side of the leadframe 12, where the dice 14 are mounted.

The enlarged view of Figure 4 also illustrates the channel-shaped tie bars 20 projecting from the body of the leadframe 12 from a recessed portion thereof, that is with two channels (notches) 20B on both sides of the tie bar 20 and extending transverse to the plane of the leadframe 12, sidewise of the tie bars 20.

Hollowed out (channel-shaped, e.g., U-shaped) tie bars 20 as illustrated in Figure 4 were found to provide a higher stiffness (a higher moment of inertia) in comparison with tie bars of a same cross-sectional area having constant (full) cross-section, thus providing improved support of the die pads avoiding tilt/bending.

Figure 5 is a comparative diagram of characteristics (moment of inertia - microns^4 v. tie bar cross-sectional area - microns^2) of:
hollowed out (channel-shaped or U-shaped) tie bars 20 as described herein (curve labeled I), and
conventional tie bars of constant (full) cross section (curve labeled II).

The diagram of Figure 5 demonstrates that providing a recess or cavity 20A in the median portion of the tie bars 20 results in:
a higher moment of inertia for a same cross-sectional area (of the median portion to be cut during singulation) and, consistently,
a same moment of inertia for a smaller cross-sectional area (of the median portion to be cut during singulation).

A smaller cross-sectional area translates into lower cutting forces (and thus lower stress) involved in singulation while an adequate flexural stiffness can be retained in order to support the associated die pad 12A avoiding tilt/bending.

Solutions as described herein facilitate achieving a two-fold advantage, namely:
pursuing a higher moment of inertia, and thus a higher stiffness and improved support for the die pads, countering tilting/bending, and
reducing the cross-sectional area, with cutting at singulation made easier with reduced singulation stresses.

Figure 6 shows that the channel shape or U-shape of the tie bars 20 will be revealed by the remainders of the tie bars being exposed at the flanks of the package of the device 10 after singulation (this may be a package including a leadframe with an exposed pad).

Two tie bars 20 at both (transversal) sides of the die pads 12A are illustrated in the figures.

Two pairs of tie bars arranged symmetrically at opposed sides of the die pads (that is, four tie bars 20 for each die pad 12A) are of course merely exemplary and non-limiting. Other arrangements such as, e.g., one tie bar and two bars arranged asymmetrically at opposed sides of the die pads (that is, three tie bars 20 for each die pad 12A) are of course possible.

Tie bars 20 as discussed herein thus facilitate having thinner (easier-to-cut) tie bars while avoiding any increased risk of die pad tilt in so far as a channel-shaped or U-shaped cross section bestows on the tie bars 20 a higher moment of inertia in comparison with a rectangular/square cross-sectional shape.

At the same time, coined/etched-out tie bars 20 will reduce the force/stress involved in separating an individual package 10 from the chain/strip during the final steps of the assembly process.

Without prejudice to the underlying principles, the details and embodiments may vary, even significantly, with respect to what has been described by way of example only without departing from the extent of protection.

The extent of protection is determined by the annexed claims.

## Claims

1. A method, comprising:
mounting semiconductor dice (14) at the first surface of die pads in a plurality of die pads (12A) in a semiconductor die mounting substrate (12), the die pads (12A) having opposed first and second surfaces as well as tie bars (20) projecting therefrom,
molding encapsulation material (16) onto the semiconductor dice (14) mounted at the first surface of die pads in the plurality of die pads (12A), wherein a plurality of semiconductor devices (10) is provided wherein the semiconductor devices (10) in the plurality are coupled via said tie bars (20) projecting from the die pads (12A), and
cutting (T) the tie bars (20) at an intermediate singulation location to singulate the plurality of semiconductor devices (10) into individual semiconductor devices (10),
wherein the tie bars (20) have a hollowed-out portion (20A) at said intermediate singulation location, wherein the tie bars (20) have at said intermediate singulation location a channel-shaped cross-sectional profile.

2. The method of claim 1, wherein the tie bars (20) have at said intermediate singulation location a channel-shaped cross-sectional profile open at the second surface of die pads in the plurality of die pads (12A) .

3. The method of claim 1 or claim 2, wherein the tie bars (20) have a length in a longitudinal direction (X20) and the tie bars (20) have said hollowed-out portion (20A) over a part of their length in said longitudinal direction (X20).

4. The method of claim 3, wherein the tie bars (20) have an hourglass shape in said longitudinal direction (X20) with an intermediate narrowed waist portion and the tie bars (20) have said hollowed-out portion (20A) at said intermediate narrowed waist portion.

5. The method of any of the previous claims, wherein the tie bars (20) project from a recessed portion of the die pads (12A) with lateral grooves (20B) located sidewise of the tie bars (20).

6. The method of any of the previous claims, wherein the semiconductor die mounting substrate (12) is a ribbon substrate comprising a plurality of die pads (12A) distributed along the length of the ribbon substrate (12) with the tie bars (20) projecting therefrom lengthwise of the ribbon substrate.

7. The method of any of the previous claims, wherein said hollowed-out portion (20A) at said intermediate singulation location results from coining or etching the semiconductor die mounting substrate (12).

8. A semiconductor die mounting substrate (12) for use in the method of any of claims 1 to 7, wherein the die mounting substrate (12) comprises a plurality of die pads (12A) having opposed first and second surfaces as well as tie bars (20) projecting therefrom the tie bars having at an intermediate singulation location, wherein the tie bars (20) have a hollowed-out portion (20A) at said intermediate singulation location, the tie bars (20) having at said intermediate singulation location a channel-shaped cross-sectional profile.

9. The substrate (12) of claim 8, wherein the tie bars (20) have at said intermediate singulation location a channel-shaped cross-sectional profile open at the second surface of die pads in the plurality of die pads (12A) .

10. The substrate (12) of claim 8 or claim 9, wherein the tie bars (20) have a length in a longitudinal direction (X20) and the tie bars (20) have said hollowed-out portion (20A) over a part of their length in said longitudinal direction (X20).

11. The substrate (12) of claim 10, wherein the tie bars (20) have an hourglass shape in said longitudinal direction (X20) with an intermediate narrowed waist portion, wherein the tie bars (20) have said hollowed-out portion (20A) at said intermediate narrowed waist portion.

12. The substrate (12) of any of claims 8 to 11, wherein the tie bars (20) project from a recessed portion of the die pads (12A) with lateral grooves (20B) located sidewise of tie bars.

13. The substrate (12) of any of claims 8 to 12, wherein the semiconductor die mounting substrate (12) is a ribbon substrate comprising a plurality of die pads (12A) distributed along the length of the ribbon substrate (12) with the tie bars (20) projecting therefrom lengthwise of the ribbon substrate.

14. A device (10), comprising:
a semiconductor die mounting substrate (12) comprising at least one die pad (12A) having opposed first and second surfaces as well as residuals of tie bars (20) projecting therefrom towards a distal singulation location,
at least one semiconductor die (14) mounted at the first surface of the at least one die pad (12A), and
encapsulation material (16) molded onto the at least one semiconductor die (14) mounted at the first surface of the at least one die pad (12A),
wherein the residuals of tie bars (20) have a hollowed-out portion (20A) at said distal singulation location, wherein the residuals of tie bars (20) have at said distal singulation location a channel-shaped cross-sectional profile.
